# EUROPEAN PATENT APPLICATION

(11) **EP 3 085 528 A1**
(43) Date of publication of application: **26.10.2016**
(21) Application number: 16163802.8
(22) Date of filing: 05.04.2016
(51) Int. Cl.: B32B 7/12, B32B 15/08, B32B 15/082, B32B 15/085, B32B 15/09, B32B 23/00, B32B 23/04, B32B 27/26, B32B 27/28, B32B 27/30, B32B 27/32, B32B 27/36, G06F 1/16, G06F 3/041, G06F 3/044, H03K 17/96, G06F 3/0354

(54) **TOUCH PANEL AND METHOD OF ITS MANUFACTURING**

(30) Priority: 20.04.2015 JP 2015085887; 01.03.2016 JP 2016039189
(71) Applicant: Hosiden Corporation, Yao-shi, Osaka 581-0071 (JP)
(72) Inventor: ISODA, Takeshi, Osaka, 5810071 (JP); AO, Hitoshi, Osaka, 5810071 (JP)
(74) Representative: Lemcke, Brommer & Partner Patentanwälte Partnerschaft mbB

(57) **Abstract**

A touch panel (20) includes a panel member (11) and a multilayer film (10) joined to a front face of the panel member (11), the multilayer film (10) including a conductive film (1, 2) having a conductive layer (1a, 2a) and a protective film (4). In the multilayer film (10), the respective films are laminated to each other via an adhesive layer (5, 6, 7) formed of a thermosetting type adhesive agent and formed in a three-dimensional shape along the front face.

## Description

### [Technical Field]

This disclosure relates to a touch panel and a method of its manufacturing.

### [Related Art]

Conventionally, a touch panel has been used as an input device for an audio equipment of an automobile, a home electric appliance, an electronic device, etc. The touch panel is formed by printing and laminating a conductive layer for detecting an electrostatic capacity change and a decorative layer respectively on a front face of a film having insulating property. Use of the touch panel provides advantages such as possibility of forming an operating face flat, possibility of omitting various switching elements for input operations, and so on.

The decorative layer to be provided in a touch panel can be selected from various kinds, in accordance with an intended use of the touch panel, user's preference, etc. However, with the arrangement of printing and laminating the decorative layer and the conductive layer on a single sheet of film, it is not readily possible to realize various combinations of the conductive layer and the decorative layer as desired. For this reason, there is known a touch panel configured such that a decorative film having a decorative layer and a conductive film having a conductive layer are joined to each other via e.g. an adhesive agent (e.g. Japanese Unexamined Patent Application Publication No. 2014-2450). By providing the decorative film and the conductive film separately, various combinations of a conductive layer and a decorative layer can be realized easily.

### [Summary]

Depending on its place of its installment, it can be advantageous for the touch panel to have a three-dimensional shape such as a curved face, for aesthetic or visibility reason. In a touch panel disclosed in Japanese Unexamined Patent Application Publication No. 2014-2450, a decorative film is joined to a conductive film via an adhesive bonding layer using an adhesive agent, by such technique as a film insert technique, a TOM (Three Dimensions Overlay Method) technique, etc. In case a touch panel is formed into a three-dimensional shape with use of the film insert technique, etc., the two films are joined to each other via the adhesive bonding layer first and then bent and shaped. Therefore, during the shaping, the hardened adhesive bonding layer can be broken. For preventing such break of the adhesive bonding layer, an adhesive tape could be used in place of the adhesive bonding layer. This would allow easy bonding of the various kinds of film material to each other. However, since the adhesive bonding force of such adhesive tape is smaller than that of the adhesive bonding layer, exfoliation of the various films from the adhesive tape at a three-dimensionally formed portion having large undulation can occur. For this reason, degree of freedom in the shape of films laminated on a touch panel would be limited.

Embodiments of this disclosure provide a touch panel whose shape can be maintained stably even when laminated films are formed into a three-dimensional shape and a method of manufacturing such touch panel.

According to one embodiment of a touch panel relating to this disclosure, a touch panel comprises:
a panel member; and
a multilayer film joined to a front face of the panel member, the multilayer film including a conductive film having a conductive layer and a protective film;
wherein in the multilayer film, the respective films are laminated to each other via an adhesive layer formed of a thermosetting type adhesive agent and formed in a three-dimensional shape along the front face.

In the above-described embodiment, the multilayer film includes a conductive film and a protective film and the respective films are laminated to each other via an adhesive layer formed of a thermosetting type adhesive agent. Therefore, under a normal temperature condition prior to heating, the adhesive layer is not yet hardened, so that the multilayer film can be shaped without breaking the adhesive layer. Hardening of the adhesive layer can take place during or after forming to the three-dimensional shape concurrently with heating of the multilayer film. For this reason, the multilayer film including the conductive film and the protective film can be formed into the three-dimensional shape with keeping the respective films placed in close contact via the adhesive layer with each other. This arrangement can inhibit occurrence of forming distortion in the multilayer film during its forming into the three-dimensional shape and can also reduce a internal stress which would invite exfoliation between the respective films and the adhesive layer. As a result, in the touch panel, the three-dimensional shape of the multilayer film can be maintained stably.

According to a further embodiment of the touch panel relating to the present disclosure, the protective film comprises a decorative film having a decorative layer.

If the protective film comprises a decorative film having a decorative layer as provided in the above-described embodiment, through appropriate selection of the decorative film to be used, various combinations of the conductive layer and the decorative layer can be easily realized in the touch panel.

According to one embodiment of a method of manufacturing a touch panel relating to the present invention, the method comprises:
a film making step for making a multilayer film by laminating a conductive film having a conductive layer and a protective film each other via an adhesive layer formed of a thermosetting type adhesive agent;
a film shaping step for forming the multilayer film into a three-dimensional shape with heating this multilayer film; and
a panel integrating step in which the formed multilayer film is placed in a mold for injection molding and molten resin is injected into the mold for molding a panel member, thereby integrating the multilayer film and the panel member to each other.

In the above-described embodiment, after a multilayer film is shaped in the film shaping step, this formed multilayer film is placed in a mold and then an injection molding is effected, whereby a touch panel is manufactured. In the above, the multilayer film is produced in the film making step in which a conductive film having a conductive layer and a protective film are laminated to each other via an adhesive layer formed of a thermosetting type adhesive agent. At the time of completion of this film making step, the adhesive layer of the multilayer film has not yet been hardened, but the viscosity thereof keeps the conductive film and the protective film joined to each other. Then, when the temperature of the multilayer film rises above the setting (hardening or curing) temperature of the thermosetting resin by heating during or after the film shaping step subsequent thereto, the adhesive agent is hardened. As described, since hardening of the adhesive agent occurs n the film shaping step, distortion of the respective films which would otherwise occur during shaping can be suppressed. Consequently, it is possible to manufacture a touch panel in which a multilayer film having a stable three-dimensional shape and a panel member are integrated to each other. Further, even if the hardening of the adhesive layer fails to be completed by the heating in the film shaping step, this hardening of the adhesive agent can be completed appropriately later by reheating the multilayer film in the subsequent panel integrating step.

### [Brief Description of Drawings]

Fig. 1 is a view showing a configuration of a multilayer film,
Fig. 2 is a perspective view showing a touch panel according to a first embodiment,
Fig. 3 is a section view taken along line III-III in Fig. 2,
Fig. 4 is a view showing the multilayer film after preliminary shaping,
Fig. 5 is a view showing a shaping step of the touch panel,
Fig. 6 is a view showing a shaping step of the touch panel,
Fig. 7 is a view showing a shaping step of the touch panel,
Fig. 8 is a view showing a shaping step of the touch panel in a different mode,
Fig. 9 is a view showing a shaping step of the touch panel in a different mode,
Fig. 10 is a perspective view showing a touch panel according to a second embodiment,
Fig. 11 is a section view taken along line XI-XI in Fig. 10, and
Fig. 12 is a perspective view showing a touch panel according to a further embodiment.

### [Description of Embodiments]

Next, embodiments of this disclosure will be explained with reference to the accompanying drawings.

### [First Embodiment]

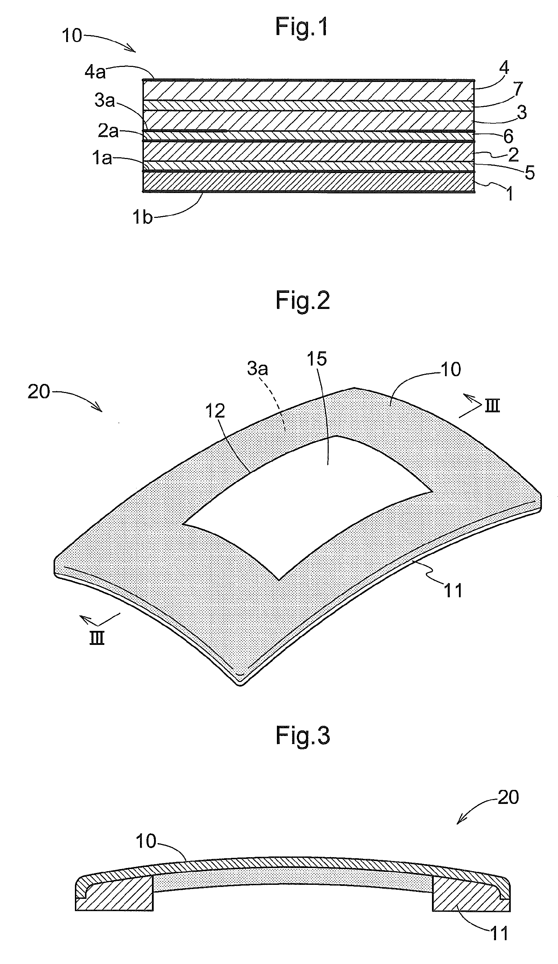

A touch panel 20, as shown in Figs. 1-3, is formed by lamination of a multilayer film 10 on a front face of a panel member 11. The panel member 11 and the multilayer film 10 are both formed into a three-dimensional shape. In this embodiment, the front face of the touch panel 20 is formed into a three-dimensional curved shape. At a center of the panel member 11, there is formed an aperture 12 which is form an operation screen of the touch panel 20.

As shown in Fig. 1, the multilayer film 10 includes first and second conductive films 1, 2 having first and second conductive layers 1a, 2a respectively, an adhesive layer 6, and a decorative film 3 having a decorative layer 3a, with these films and layers being laminated to each other one after another. On the front face side (the upper side in Fig. 1) of the decorative film 3, there is further laminated, via an adhesive layer 7, a protective film 4 having a protective layer 4a.

The first conductive film 1 and the second conductive film 2 respectively include the first conductive layer 1a and the second conductive layer 2a on the front face side of respectively base films thereof. The first conductive film 1 and the second conductive film 2 are laminated to each other via an adhesive layer 5. The first conductive layer 1a is configured to detect a coordinate position in a first predetermined direction and the second conductive layer 2a is configured to detect a coordinate position in a second predetermined direction intersecting the first predetermined direction, for instance. Therefore, the combination of these first and second conductive films 1, 2 provides a function as a touch sensor. In this embodiment, the touch sensor is comprised of the two sheets of films, i.e. the first conductive film 1 and the second conductive film 2. Instead, the touch sensor can be comprised of a single sheet of conductive film.

The decorative film 3 includes the decorative layer 3a on a back face side of its base film. The decorative layer 3a is formed by such technique as screen printing or transfer. The decorative layer 3a is non-light-transmitting and provided with a decorative design or coloring suitable for the touch panel 20.

The protective film 4 includes the protective layer 4a on the front face side of its base film. As an example of the protective layer 4a, an amount of hard coating material is applied thereto. With this, the protective film 4 provides such functions as scratch resistance, low light reflection, antiglare, fingerprint prevention, scratch repair, refractive index adjustment, retardation adjustment, etc.

Alternatively, the protective film 4 can omit the protective layer 4a and can be formed of a base film which is configured as described next.

The base films of the respective films 1-4 are not particularly limited and can be polyethylene terephthalate (PET), polycarbonate (PC), acryl (PMMA), cycloolefin polymer (COP), polypropylene (PP), polyethylenenaphthalate (PEN), triacetyl cellulose (TAC), polyimide (PI), etc. These base films of the respective films 1-4 can all be a same material or can be different materials.

All of the adhesive layers 5-7 are formed of thermosetting adhesive agent. Preferably, the thermosetting resin has viscosity at a normal temperature. The kind of the thermosetting resin is not particularly limited, but a preferred example thereof is a thermosetting optical clear adhesive agent (OCA).

The thermosetting adhesive agent can have a certain degree of viscoelasticity as well after its hardening. Between the adjacent ones of the respective films 1-4, there can exist fine difference in the moldability or difference of physical properties such as heat shrinkage, linear expansion coefficient, etc. In such cases, if the thermosetting adhesive agent having viscoelasticity is employed, such difference of moldability or physical properties among the respective films 1-4 can be absorbed as the adhesive layers 5-7 act as "buffers", whereby inadvertent exfoliation of the respective films 1-4 can be prevented.

The thermosetting adhesive agent can have rigidity after its hardening. In this case, influence of distortions occurring in the respective films 1-4 can be isolated from each other by the rigidity of the adhesive layers 5-7, whereby inadvertent exfoliation of the respective films 1-4 can be prevented.

The multilayer film 10 is formed by applying the adhesive layers 5-7 to the respective front face sides of the first conductive film 1, the second conductive film 2, and the decorative film 3 in lamination. Incidentally, on the back face side of the conductive film 1, there is applied a binder 1b suitable for bonding with the panel member 11.

### [Method of Manufacturing Touch Panel]

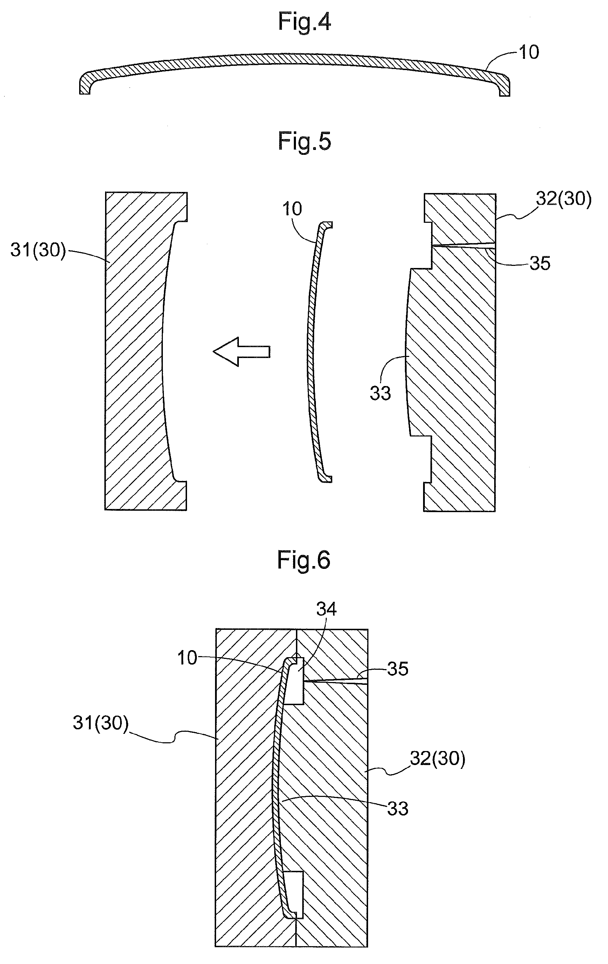

Next, a method of manufacturing the touch panel 20 by a film insert technique will be explained. This method of manufacturing the touch panel 20, as shown in Figs. 4 through 7, includes a film making step of making the multilayer film 10, a film shaping step for forming the multilayer film 10 into a three-dimension shape with concurrent heating of this multilayer film 10, and a panel integrating step in which the formed multilayer film 10 is placed in a mold 30 for injection molding and molten resin is injected into the mold 30 for molding the panel member 11, thereby integrating the formed multilayer film 10 and the formed panel member 11 to each other.

In the unillustrated film making step, the conductive films 1, 2 having the conductive layers 1a, 2a respectively, the decorative film 3 having the decorative layer 3a and the protective film 4 having the protective layer 4a are laminated to each other via the adhesive layers 5-7 formed of adhesive agent. At the time of completion of this film making step, the adhesive layers 5-7 are not yet hardened, but the viscosities thereof keep the respective films 1-4 joined to each other. In the multilayer film 10 illustrated in Fig. 2, the decorative layer 3a is not formed at least in a light-transmitting region 15 to be overlapped with the aperture 12 of the panel member 11. Instead of the arrangement of Fig. 2, the decorative layer 3a can be formed in at least a part of the light-transmitting region 15 in the multilayer film 10.

In the film shaping step, as shown in Fig. 4, the multilayer film 10 is formed into a three-dimensional shape while being heated. The preliminary shaping of the multilayer film 10 can be effected by heat press, vacuum molding, pressurized-air molding, etc. Then, when the temperature of the multilayer film 10 exceeds a hardening (curing) temperature of the thermosetting adhesive agent in the adhesive layers 5-7 by the heating at the film shaping step, the adhesive layers 5-7 will be hardened (cured)

Next, as shown in Fig. 5, the multilayer film 10 after its preliminary shaping is placed in the mold 30 for injection molding in such a manner that the film 10 is placed along an inner contour of one molding die 31. As shown in Fig. 6, when the mold 30 is closed, a projection 33 of the other molding die 32 comes into contact with the multilayer film 10, thus forming a cavity 34 around the projection 33.

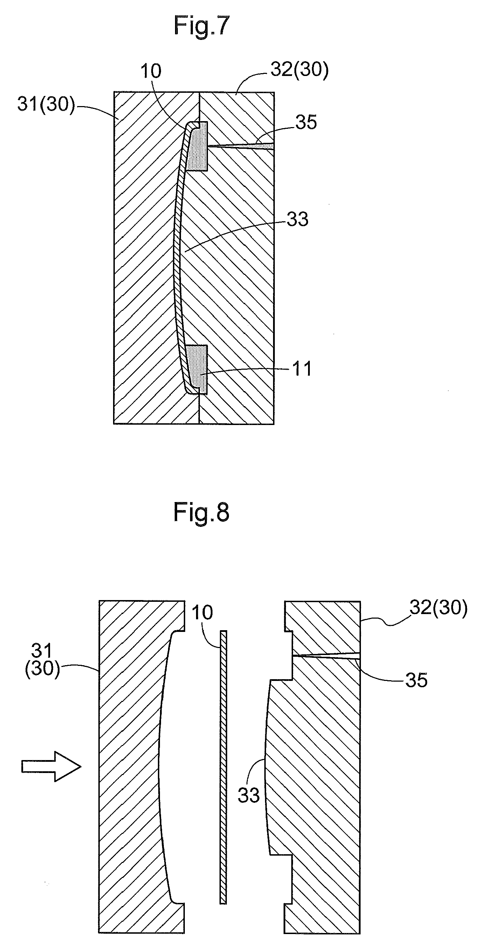

Thereafter, as shown in Fig. 7, an amount of molten resin is injected through a gate 35 into the cavity 34, whereby the panel member 11 is formed and also the three-dimensionally shaped multilayer film 10 and the panel member 11 are integrated to each other. Through this panel integrating step, the touch panel 20 will be manufactured.

As described above, the adhesive layers 5-7 are hardened through heating of the multilayer film 10 in the film shaping step. Therefore, the multilayer film 10 can be formed into a three-dimensional shape with the respective films 1-4 being kept in close contact via the adhesive layers 5-7. This arrangement can inhibit occurrence of formation distortion in the multilayer film 10 during its forming into the three-dimensional shape and can also reduce a internal stress which would invite exfoliation between the respective films 1-4 and the adhesive layers 5-7. As a result, it is possible to manufacture the touch panel 20 in which the stable three-dimensionally shaped multilayer film 10 and the panel member 11 are integrated to each other. Further, even if the hardening of the adhesive layers 5-7 fails to be completed by the heating in the film shaping step, this hardening of the adhesive agent can be completed appropriately later by reheating the multilayer film 10 in the subsequent panel integrating step.

When preliminary shaping of the multilayer film 10 is effected in the film shaping step, the multilayer film 10 will be heated generally to 60 to 100°C. Therefore, a difference of hardening starting temperature of the thermosetting adhesive agent will result in different actions corresponding thereto.

As the thermosetting adhesive agent for forming the adhesive layers 5-7, an agent which starts hardening at a temperature higher than 60°C can be used for instance. In this case, no hardening of the adhesive layers 5-7 will occur in the film making step, but hardening of the adhesive layers 5-7 will start with the heating for preliminary shaping in the film shaping step.

Alternatively, the thermosetting adhesive agent can be such agent which starts hardening at a temperature higher than 100°C. In this case, the adhesive layers 5-7 will be hardened by setting the heating temperature of the multilayer film 10 in the film shaping step to a rather high range. Therefore, in case e.g. an autoclave (sterilization) treatment or an anneal treatment is to be effected on the multilayer film 10 prior to the film shaping step, the adhesive layers 5-7 will not be hardened, but such hardening will occur only in the film shaping step thereafter. Further, by setting the heating temperature in the film shaping step low, it becomes possible to inhibit start of hardening of the adhesive layers 5-7 in the multilayer film 10 in the film shaping step, but to allow hardening of the adhesive layers 5-7 to take place in the panel integrating step.

Further alternatively, the thermosetting adhesive agent to be employed can start hardening at a temperature higher than 250°C. In this case, the hardening start temperature of the thermosetting adhesive agent becomes higher than the heating temperature employed in the preliminary shaping in the film shaping step. Therefore, when the multilayer film 10 is set within the mold 30, the adhesive layers 5-7 will not have been hardened yet. Therefor, even if the multilayer film 10 is disposed within the mold 30 with a certain gap relative thereto in the panel integrating step, the multilayer film 10 will be "corrected" to the contour of the mold 30 by the injecting pressure of molten resin, and as the multilayer film 10 is heated also by the molten resin under this condition, the adhesive layers 5-7 can be hardened.

### [Other Manufacturing Method of Touch Panel]

As shown in Figs. 8-9, a multilayer film 10 in the form of a flat plate can be inserted into the mold 30 and the shaping of this multilayer film 10 can be effected inside the mold 30. Then, the multilayer film 10 will be heated by e.g. an unillustrated heat source and will be shaped to conform to the contour of the mold die 31. Thereafter, the mold 30 will be closed, and an amount of molten resin will be injected into the cavity 34 through the gate 35 to form the panel member 11. With this, there will be produced a touch panel 20 comprising the three-dimensionally shaped multilayer film 10 integrated with the panel member 11.

The multilayer film 10 to be inserted into the mold 30 can be shaped firstly at least partially to conform to the contour of the mold 30 by a pressing force applied at the time of closing of the mold 30, and then injection molding with molten resin can be allowed to take place. With this arrangement, the multilayer film 10 will be shaped as receiving the pressure from the molten resin and also the adhesive layers 5-7 will be heated also by this molten resin and hardened thereby.

### [Second Embodiment]

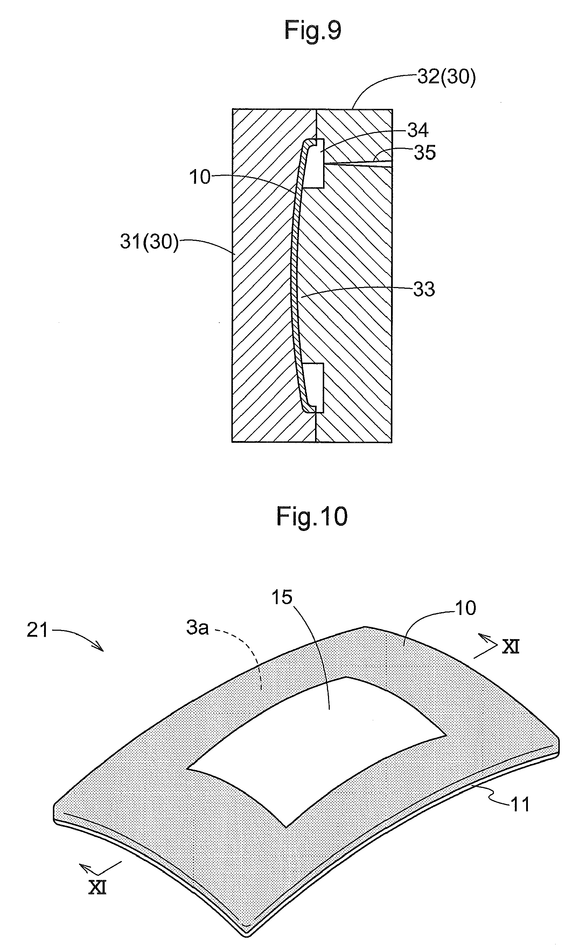

In a second embodiment, a touch panel 21, as shown in Figs. 10-11, is configured such that the multilayer film 10 is laminated on the entire front face of a panel member 11 having no aperture. The panel member 11 and the multilayer film 10 are both formed into three-dimensional shape. The panel member 11 is formed of a transparent resin such as polycarbonate and formed into a shape approximately same as that of the multilayer film 10. In the multilayer film 10 shown in Fig. 10, no decorative layer 3a is formed in the light-transmitting region 15 which is to form the operation screen. Instead of this arrangement shown in Fig. 10, in the multilayer film 10, the decorative layer 3a can be formed at a part of the light-transmitting region 15. The touch panel 21 can be manufactured by the same manufacturing method as that employed in the first embodiment.

By forming the multilayer film 10 and the panel member 11 into a same shape and then laminating them to each other, it becomes possible to ensure a stable strength that allows the touch panel 21 to satisfy the required specification over the entire face thereof. With this, durability of the touch panel 21 is improved. Further, though not shown, the touch panel 21 can alternatively employ a multilayer film 10 having no decorative layer 3a. In such case, the entire face of the multilayer film 10 can be used as the operation screen of the touch panel 21.

### [Other Embodiments]

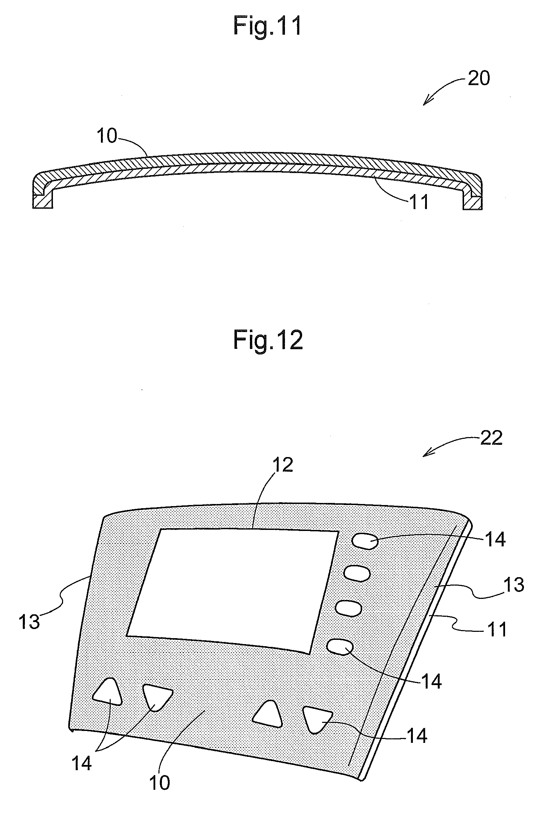

(1) Fig. 12 shows a touch panel 22 according to a further embodiment. In this touch panel 22, its front face is formed into a three-dimensional curved shape and left and right end portions 13 are bent substantially at a right angle respectively. Further, on the front face side of the touch panel 22, there are provided section portions 14 that allow pressing operations respectively. These section portions 14 can be provided in the touch panel 20 in the first embodiment and/or the touch panel 21 in the second embodiment also.
(2) In the respective embodiments described above, there was disclosed an arrangement of the multilayer film 10 having the conductive films 1, 2, the decorative film 3 and the protective film 4. Instead, the multilayer film 10 can omit the protective film 4. In this case, the outermost layer of the multilayer film 10 will be constituted of the decorative film 3, so this decorative film 3 will act also as a protective film. Namely, the protective film of the multilayer film 10 is constituted of the decorative film 3. Further, the multilayer film 10 can comprise only the conductive films 1, 2 and the protective film 4, without the decorative film 3.
(3) In the multilayer film 10, between the conductive films 1, 2, a "dummy" film can be laminated for adjustment of sensitivity of the touch panel 20. This dummy film can be constituted of the base film per se of the respective films 1-4. Namely, the dummy film will be a film with omission of the conductive layers 1a, 2a, the decorative layer 3, the protective layer 4a, etc. Further, between the conductive films 1, 2 and the protective film 4, the dummy film alone can be laminated or both the dummy film and the decorative film 3 can be laminated. With use of such dummy film, thickness adjustment of the multilayer film 10 will become easy. The respective films (conductive films 1, 2, decorative film 3, protective film 4, dummy film) all will be laminated via an adhesive layer formed of a thermosetting adhesive agent.
(4) Each of the projective film 4, the decorative film 3 and the dummy film to be included in the multilayer film 10 can be provided singly or in plurality. In the case of a plurality of films of a same kind too, such films will be laminated via an adhesive layer formed of a thermosetting adhesive agent.
(5) In the respective foregoing embodiments, there was disclosed the arrangement of the front face of the respective touch panel 20-22 being formed into three-dimensional curved shape. However, the front face of the touch panel can have any desired three-dimensional shape, or can even have a shape other than a curved face shape.
(6) In the respective foregoing embodiments, there was shown the arrangement in which the conductive layers 1a, 2a are formed on the front faces of the conductive films 1, 2, respectively and the decorative layer 3 is formed on the back face of the decorative film 3. However, the conductive layers 1a, 2a can also be formed on the back face sides of the conductive films 1, 2, respectively. Further, the ornamental layer 3a can be formed on the front face side of the decorative film 3.
(7) In the respective foregoing embodiments, there was shown an example wherein the multilayer film 10 and the panel member 11 are integrated to each other with using the film insert technique. However, the TOM technique can be employed instead of the film insert technique.

## Claims

1. A touch panel (20) comprising:
a panel member (11); and
a multilayer film (10) joined to a front face of the panel member (11), the multilayer film (10) including a conductive film (1, 2) having a conductive layer (1a, 2a) and a protective film (4);
wherein in the multilayer film (10), the respective films are laminated to each other via an adhesive layer (5, 6, 7) formed of a thermosetting type adhesive agent and formed in a three-dimensional shape along the front face.

2. The touch panel according to claim 1, wherein the protective film (4) comprises a decorative film (3) having a decorative layer (3a).

3. A method of manufacturing a touch panel (20), the method comprising:
a film making step for making a multilayer film (10) by laminating a conductive film (1, 2) having a conductive layer (1a, 2a) and a protective film (4) each other via an adhesive layer (5, 6, 7) formed of a thermosetting type adhesive agent;
a film shaping step for forming the multilayer film (10) into a three-dimensional shape with heating this multilayer film (10); and
a panel integrating step in which the formed multilayer film (10) is placed in a mold (30) for injection molding and molten resin is injected into the mold (30) for molding a panel member (11), thereby integrating the multilayer film (10) and the panel member (11) to each other.
